# EUROPÄISCHE PATENTANMELDUNG

(11) **EP 1 521 067 A2**
(43) Veröffentlichungstag der Anmeldung: **06.04.2005**
(21) Anmeldenummer: 04021937.0
(22) Anmeldetag: 15.09.2004
(51) Int. Cl.: G01J 1/00

(54) **Optisches Abbildungssystem**

(30) Priorität: 01.10.2003 DE 10345783
(71) Anmelder: Carl Zeiss SMS GmbH, 07745 Jena (DE)
(72) Erfinder: Engel, Thomas, Dr., 99102 Erfurt OT Niedernissa (DE)
(74) Vertreter: Breit, Ulrich

(57) **Zusammenfassung**

Es wird beschrieben ein optisches Abbildungssystem, das ein Objekt (2) in eine Bildebene (3) abbildet und das aufweist einen Beleuchtungsstrahlengang (5), in den Beleuchtungsstrahlung in einem Wellenlängenbereich unterhalb 100 nm eingekoppelt wird und der zur Einstellung der numerischen Apertur der Beleuchtung eine Sigma-Blende (8) aufweist, einen Abbildungsstrahlengang (6), der zur Einstellung der numerischen Apertur der Abbildung eine NA-Blende (10) aufweist und in der Bildebene (3) ein vergrößertes Bild der Maske (2) erzeugt, wobei Beleuchtungs- und Abbildungsstrahlengang (5, 6) eine reflektive Optik (7, 9) aufweisen, wobei eine Justierabbildungseinrichtung (11, 15, 16, 17, 6) vorgesehen ist, die die gegenseitige Lage von Sigma- und NA-Blende (8, 10) abbildet.

## Beschreibung

Die Erfindung bezieht sich auf ein optisches Abbildungssystem, das ein Objekt in eine Bildebene abbildet und das einen Beleuchtungsstrahlengang, in den Beleuchtungsstrahlung in einem Wellenlängenbereich unterhalb 100 nm eingekoppelt wird und der zur Einstellung der numerischen Apertur der Beleuchtung eine Sigma-Blende aufweist, und einen Abbildungsstrahlengang aufweist, der zur Einstellung der numerischen Apertur der Abbildung eine NA-Blende aufweist und in der Bildebene ein vergrößertes Bild der Maske erzeugt, wobei Beleuchtungs- und Abbildungsstrahlengang eine reflektive Optik aufweisen.

Solche optischen Abbildungssysteme werden beispielsweise als Röntgenmikroskope oder in der Halbleiterindustrie zur Inspektion von Photolithographiemäsken verwendet. Ein Beispiel ist ein sogenanntes Arial Image Measurement System (AIMS), das für die Maskeninspektion eingesetzt wird. Da mit steigenden Auflösungsanforderungen bei der Halbleiterfertigung die verwendete Wellenlänge immer kurzwelliger wird, sind in solchen optischen Abbildungssystemen die Abbildungen fast vollständig, mit Spiegeln ausgeführt, da es für herkömmliche, transmittierende Optiken keine geeigneten Materialien gibt, die bei Wellenlängen von deutlich kleiner als 100 nm (z.B. 13,5 nm) Transmissionseigenschaften hätten, die es erlauben würden, ein Abbildungssystem aufzubauen. Die Abbildungseigenschaften werden deshalb in diesen Wellenlängenbereichen durchgängig mittels geeigneter Bündelungs- oder Zerstreuungsspiegel, d.h. mit retlektiven Optiken, erreicht.

Bei solchen optischen Abbildungssystemen ist es regelmäßig erforderlich, die numerische Apertur der Beleuchtung bzw. der Abbildung über die zwei erwähnten Blenden (Sigma-Blende und NA-Blende) einzustellen. Bei AIMS müssen beispielsweise zur Simulation von in der Halbleiterindustrie verwendeten Steppern auch die in solchen Steppern verwendeten Aperturen für Beleuchtung und Abbildung nachgebildet werden. Dies macht in Fertigung oder Anpassung und insbesondere auch während des Betriebes eine korrekte Ausrichtung, insbesondere Zentrierung der entsprechenden Pupillen unerläßlich. Für die eingangs erwähnten optischen Abbildungssysteme mit vorwiegend reflektiven Optiken gibt es diesbezüglich keinen zufriedenstellenden Ansatz.

Es ist deshalb Aufgabe der Erfindung, ein optisches Abbildungssystem der eingangs genannten Art so weiterzubilden, daß die erforderliche Justierung möglich ist.

Diese Aufgabe wird erfindungsgemäß dadurch gelöst, daß eine Justierabbildungseinrichtung vorgesehen wird, die die gegenseitige Lage von Sigma- und NA-Blende abbildet.

Erfindungsgemäß ist das optische Abbildungssystem also mit einer Justierabbildungseinrichtung ausgestatten, die die zu justierenden Aperturblenden abbildet. Mit Hilfe dieser Abbildung ist nun einfach eine Justage und Zentrierung möglich.

Für die Justierabbildungseinrichtung kommen dabei verschiedenste Varianten in Frage. In einer ersten Variante kann eine Fresnellinse als sogenannte Bertrandoptik verwendet werden, die die Pupillen der zu justierenden optischen Elemente in die Bildebene abbildet. Die Verwendung einer solchen Fresnellinse ist bei einem mit optischer UV-Strahlung arbeitenden abbildenden System per se überraschend, da Fresnellinsen wegen des hohen Absorptionsgrades im UV bislang für solche optischen Abbildungssysteme nicht verwendbar schienen. Die Dämpfung von UV-Strahlung, insbesondere im Wellenlängenbereich unter 100 nm, beispielsweise bei 13,5 nm, die eine Fresnellinse mit sich bringt, ist jedoch überraschenderweise für die Justierabbildungseinrichtung vorteilhaft, da bei der Justierung der Blenden die in die Bildebene abzubildende Maske ohnehin durch ein neutrales Objekt, beispielsweise einen Spiegel, ersetzt wird und im Pupillenbild eines Mikroskopes zur Maskeninspektion typischerweise ein um eine Größenordnung höherer Lichtfluß als beim späteren Einsatz der Maske eingestellt ist, wie im Mikroskop mit Überausleuchtung des Feldes gearbeitet wird. Somit wird eine Abschwächung der im Abbildungsstrahlengang laufenden Strahlung ohnehin gewünscht wird. Die im Stand der Technik als nachteilig empfundenen absorbierenden Eigenschaften einer Fresnellinse, die diese für die Verwendung in reflektiv-optischen Abbildungssystemen im UV-Bereich ausscheiden ließen, machen eine Fresnellinse für die Justierabbildungsanrichtung also überraschenderweise besonders geeignet. Die Fresnel-Zonenplatte erlaubt es somit als Bertrand-Optik unter Weitemutzung des normalen Abbildungsstrahlengangs des optischen Abbildungssystems, die zu zentrierenden Pupillen in die im optischen Abbildungssystem ohnehin vorgesehene Bildebene abzubilden. Die Detektion erfolgt dann mit den im optischen Abbildungssystem in der Bildebene ohnehin vorgesehenen Mitteln, beispielsweise einer geeigneten Kamera.

Um die Justierung zu ermöglichen, ist die Fresnellinse in den Abbildungsstrahlengang einschwenkbar, wodurch die Justierabbildungseinrichtung aktiv wird und das optische Abbildungssystem in einen Hilfszustand überführt wird, in dem die normale Abbildung der Maske nicht möglich ist, hingegen die Justierung und Zentrierung der Blenden erfolgen kann.

In einer weiteren Variante der Erfindung weist die Justierabbildungseinrichtung einen Abbildungsspiegel auf, der mittels mindestens zweier in den Abbildungsstrahlengang schaltbarer Spiegel in den Abbildungsstrahlengang des optischen Abbildungssystems einkoppelbar ist und der über geeignete Abbildungseigenschaften verfügt, so daß die Pupillen die Sigma- und die NA-Blende in die Bildebene abgebildet werden. Ein Einschalten dieses Abbildungsspiegels verbringt das optische Abbildungssystem also ebenfalls in den Hilfszustand, in dem in der Bildebene die Pupillenbilder der Sigma- und der NA-Blende erkennbar sind, was die gewünschte Zentrierung bzw. Justierung ermöglicht. Der Abbildungsspiegel fungiert also als Zwischenabbildungssystem und wirkt analog der Fresnellinse mit dem übrigen Abbildungsstrahlengang des optischen Abbildungssystems zusammen, d.h. nutzt diesen aus. Eventuelle Verluste durch die zusätzlich eingeschalteten Spiegel spielen keine große Rolle, da in der Pupillenabbildung im Vergleich zur herkömmlichen Maskenabbildung ohnehin eine höhere Strahlungsintensität zur Verfügung steht, wie bereits erläutert.

In einer weiteren Variante der Erfindung weist die Justierabbildungsvorrichtung einen in den Abbildungsstrahlengang schaltbaren Spiegel bzw. Strahlteiler oder Umlenker (z.B. Gitter) auf, der die Pupillen der Sigma- und der NA-Blende mit einem eigenständigen Abbildungssystem erfaßbar macht. Dieses derart eingekoppelte zusätzliche Abbildungssystem dient dann als Pupillenkamera und arbeitet mit der Strahlung aus dem Beleuchtungsstrahlengang, d.h. im kurzen Wellenlängenbereich unterhalb 100 mn, beispielsweise bei 13,5 nm.

Statt der Verwendung eines Abbildungsspiegels, der über zwei (in der Regel nicht abbildende) Spiegel in den Abbildungsstrahlengang eingekoppelt wird, kann der Abbildungsstrählengang des optischen Abbildungssystems mittels zweier abbildender Spiegel derart verändert werden, daß die Pupillen, d.h. der Sigma- und NA-Blende, in die Bildebene abgebildet werden. Auch hierbei wird der Abbildungsstrahlengang weiter genutzt, und die Beleuchtungsstrahlung stammt aus dem Beleuchtungsstrahlengang.

Eine weitere Variante des erfindungsgemäßen Konzeptes wird durch ein getrenntes Abbildungssystem verwirklicht, das zwei eigenständige, jeweils als Pupillenkamera arbeitende Abbildungssysteme aufweist, wobei eine Pupillenkamera die Lage der Sigma- und die andere Pupillenkamera die Lage der NA-Blende erfaßt. Die beiden Pupillenkameras sind auf einen bezüglich dem Beleuchtungs- und Abbildungsstrahlengang festliegenden Referenzpunkt fixiert und liefern ihre Signale an ein Auswertungssystem, das die erfaßten Pupillenbilder unter Berücksichtigung der Lage der Pupillenkameras so überlagert, daß die gegenseitige Lage der Pupillen im Strahlengang des zu justierenden optischen Abbildungssystems korrekt wiedergegeben wird. Die Pupillenkameras können eine andere Arbeitswellenlänge nutzen. Dazu ist es vorteilhaft eine Hilfsbeleuchtungsquelle vorzusehen, die parallel oder alternativ zur normalen Beleuchtungsquelle verwendet wird; z.B. kann sie in den Beleuchtungsstrahlengang eingeschoben, geschwenkt oder gespiegelt werden. Ist die Strahlung der Hilfsbeleuchtungsquelle zusätzlich eingekoppelt, kann während des normalen Betriebs die Justierung überwacht werden, sozusagen "on-line". Die Hilfsbeleuchtungsquelle kann natürlich auch bei der Variante mit nur einer Pupillenkamera verwendet werden. Da die Optik des zu justierenden Abbildungssystems mit reflektiven Elementen ausgeführt ist, ist bei diesem Ansatz eine dispersive Strahlablenkung nicht zu befürchten, die bei transmissiven optischen Abbildungssystemen ein getrenntes Abbildungssystem bei anderen Wellenlängen in der Regel nicht zuläßt.

Der Vorteil zweier getrennter Pupillenkameras ist, daß die Abbildung auf die Lage der Blende scharf eingestellt werden kann, während die Abbildung mit dem Abbildungsstrahlengang des zu justierenden optischen Systems mitunter unterschiedliche Kantenschärfe entlang der Konturlinie der Blende zeigt. Wesentlich für die Pupillenkameras ist jedoch der bekannte Lagebezug zum Strahlengang des zu justierenden reflektiven optischen Abbildungssystems, was beispielsweise durch die Beobachtung von Bezugspunkten im Bild der Pupillenkamera erreicht werden kann.

Die Erfindung wird nachfolgend unter Bezugnahme auf die Zeichnungen noch näher erläutert. In den Zeichnungen zeigt:
- Fig. 1: eine schematische Darstellung des Strahlengangs eines optischen Abbildungssystems mit einer ersten Ausführungsform einer Justierabbildungseinrichtung,
- Fig. 2: eine Darstellung ähnlich der Figur 1 mit einer zweiten Ausführungsform einer Justierabbildungseinrichtung,
- Fig. 3: eine Darstellung ähnlich der Figur 1 mit einer dritten Ausführungsform einer Justierabbildungseinrichtung,
- Fig. 4: eine Darstellung ähnlich der Figur 1 mit einer vierten Ausführungsform einer Justierabbildungseinrichtung und
- Fig. 5: eine Darstellung ähnlich der Figur 1 mit einer fünfte Ausführungsform einer Justierabbildungseinrichtung.

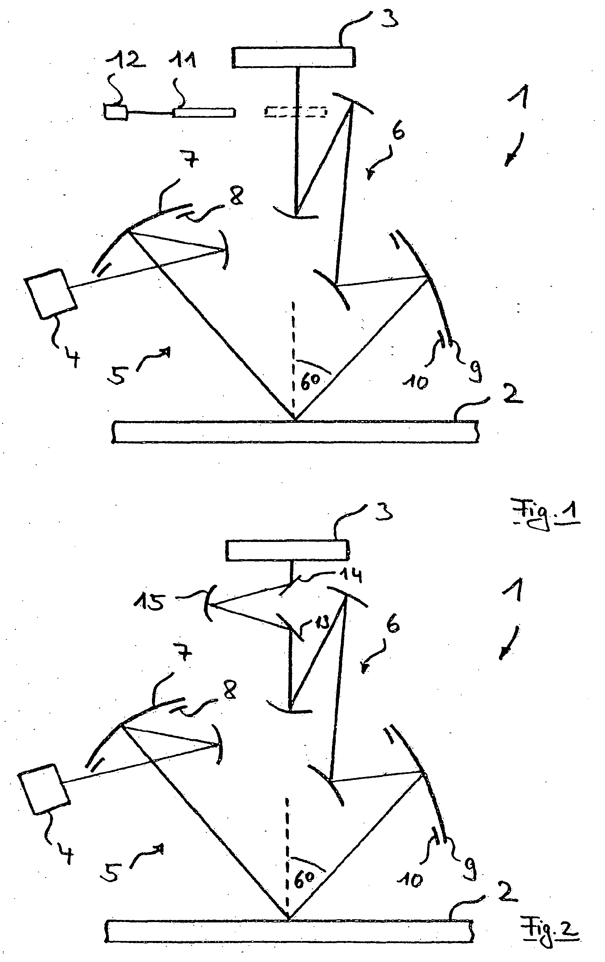

Figur 1 zeigt schematisch ein Arial Image Measurement System (AIMS) 1, das mit Strahlung im UV-Bereich arbeitet und einen Ausschnitt einer Maske 2, die im Reflexionsbetrieb ausgelesen werden soll, auf eine Kamera 3 abbildet. Das AIMS 1 dient zur Inspektion der Maske 2 und bildet die optischen Verhältnisse eines für die Halbleiterfertigung eingesetzten Steppers nach. Aufgrund der zu verwendenden Wellenlänge erfolgt die Konditionierung der Beleuchtungsstrahlung ebenso wie die Abbildung der Maske 2 auf die Kamera 3 ausschließlich mittels einer reflektiven Optik mit entsprechenden abbildenden Spiegeln.

Die UV-Strahlung einer Strahlungsquelle 4 fällt in einem Beleuchtungsstrahlengang 5 auf die Maske 2, und dort reflektierte Strahlung wird in einem Abbildungsstrahlengang 5 zur Kamera 3 gelenkt, so daß diese ein vergrößertes Bild eines Ausschnittes der Maske 2 empfängt.

Die numerische Apertur der Beleuchtung wird im Beleuchtungsstrahlengang 5 mittels einer einen Beleuchtungsspiegel 7 begrenzenden Sigma-Blende 8 eingestellt. Die numerische Apertur im Abbildungsstrahlengang, dessen optische Achse unter einem Winkel von etwa 6° auf die Maske 2 gerichtet ist, wird durch eine einen Abbildungsspiegel 9 vorgeschaltete und diesen begrenzende NA-Blende 10 eingestellt.

Justierfehler des AIMS 1 im Abbildungsstrahlengang 6 oder Beleuchtungsstrahlengang 5 wirken sich in unerwünschten Abbildungsfehlern aus, die beispielsweise durch eine Dezentrierung oder Defokussierung (sog. Telezentriefehler) verursacht sein können. Es ist deshalb erforderlich, daß die optischen Elemente, insbesondere die Sigma-Blende 8 und die NA-Blende 10 in gewünschten geometrischen Positionen liegen und insbesondere zueinander justiert sind.

Um diesen Zustand herstellen zu können, umfaßt das AIMS 1 in einer ersten Variante eine als Fresnel-Zonenplatte ausgebildete Bertrand-Linse 11, die mittels eines Antriebes 12 in den Abbildungsstrahlengang 6 eingeschoben werden kann (auch manuelle Betätigung ist natürlich möglich). Sie liegt dann in der in Figur 1 gestrichelt eingezeichneten Stellung vor der Kamera 3. Bei eingeschobener Bertrand-Linse 11 befindet sich das AIMS 1 in einem Hilfszustand und die Bertrand-Linse 11 wirkt mit der Optik des Abbildungsstrahlenganges 6 so zusammen, daß die Pupillen der NA-Blende 10 sowie der Sigma-Blende 8 auf die Kamera 3 abgebildet werden können. Die dadurch erreichten Meßbilder ermöglichen es, die Justierlage von NA-Blende 10 und Sigma-Blende 8 zu erkennen, und die gewünschte Justierung kann herbeigeführt werden. Die Bertrand-Linse 11 wird dazu auf die entsprechende Pupille fokussiert und die Pupille anhand der Abbildung zentriert.

Im einzelnen werden zur Justierung folgende Schritte ausgeführt.

Zuerst schwenkt der Antrieb 12 die Bertrand-Linse 11 zur Beobachtung der Pupillenebene der NA-Blende 10 ein. Dann wird die Bertrand-Linse 11 auf die Pupille des Abbildungsobjektives, das der Abbildungsstrahlengang 6 enthält, fokussiert und anhand dieser Pupillenabbildung auf die Mitte der Meßkamera zentriert, sowie diese Lage als Referenzposition gespeichert. Nun wird die bislang noch nicht eingesetzte Sigma-Blende 8 eingesetzt oder aktiviert und auf die bislang gegebene Justierposition eingestellt. Ist die Bertrand-Optik, d.h. die Bertrand-Linse 11, auf die Blendenposition der Sigma-Blende 8 fokussiert, kann die Sigma-Blende 8 bezüglich der Referenzlage justiert werden.

Anschließend wird die Sigma-Blende 8 herausgenommen oder deaktiviert und die bislang noch nicht aktive NA-Blende 10 eingesetzt bzw. aktiviert. Die NA-Blende 10 wird so verschoben, bis sie mittels der Bertrand-Optik scharf auf die Kamera 8 abgebildet ist. Gleichzeitig erfolgt eine Zentrierung der NA-Blende 10 auf die gespeicherte Referenzposition. Nachdem die Sigma-Blende 8 in die gerade bestimmte Stellung wieder eingeschoben und die Bertrand-Linse 11 ausgeschwenkt ist, ist der Justiervorgang abgeschlossen.

Liegt dennoch ein Rest-Abbildungsfehler vor, der durch eine Dezentrierung der Blenden in Beleuchtungs- und Abbildungsstrahlengang verursacht ist, kann für eine iterative Korrektur der Rest-Abbildungsfehler durch Verschiebung der Na-Blende 10 behoben werden. Anschließend wird für einen Iterationsschritt die Bertrand-Linse 11 eingeschwenkt und die Sigma-Blende 8 deaktiviert bzw. herausgenommen. Dann wird die durch die vorherige Verschiebung verursachte Dezentrierung der NA-Blende 10 bestimmt und eine neue Referenzposition aus der Kombination der bisherigen gespeicherten Referenzposition unter Berücksichtigung der gerade ermittelten Dezentrierung eingestellt. Dabei kann es sich beispielsweise um die alte Referenzposition korrigiert um die halbe Dezentrierung handeln. Dann wird die NA-Blende 10 auf diese neue Referenzposition einjustiert und anschließend die Sigma-Blende 8 aktiviert bzw. eingeschoben und ebenfalls auf die neue Referenzposition justiert. Nach Ausschwenken der Bertrand-Linse 11 ist der Justierschritt abgeschlossen. Das Verfahren kann beliebig oft wiederholt werden.

Figur 2 zeigt eine weitere Ausführungsform einer Justierabbildungseinrichtung zur Justierung des AIMS 1. Anstelle der Bertrand-Linse 11 sind hier ein Auskoppelspiegel 13 sowie ein Einkoppelspiegel 14 vorgesehen, die den zur Kamera 3 verlaufenden Strahlengang auf einen zwischengeschalteten, abbildenden Bertrand-Spiegel 15 umlenken. Der Bertrand-Spiegel 15 wirkt somit als Zwischenabbildungssystem, das zusammen mit dem restlichen Abbildungsstrahlengang 6 eine Pupillenabbildung analog der Bertrand-Linse 11 bewirkt. Das geschilderte Justierverfahren kann auch hier angewendet werden.

Figur 3 zeigt eine Abwandlung des Zwischenabbildungssystems, bei dem hier nun zwei Bertrand-Spiegel 16, 17 zum Einsatz kommen. Diese haben in Verbindung mit dem weiter genutzten Abbildungssystem abbildende Eigenschaften und verändern die Abbildungseigenschaften des Abbildungsstrahlenganges 6 so, daß die gewünschte Pupillenabbildung erreicht ist, die ebenfalls das erwähnte Justiervorgehen ermöglicht.

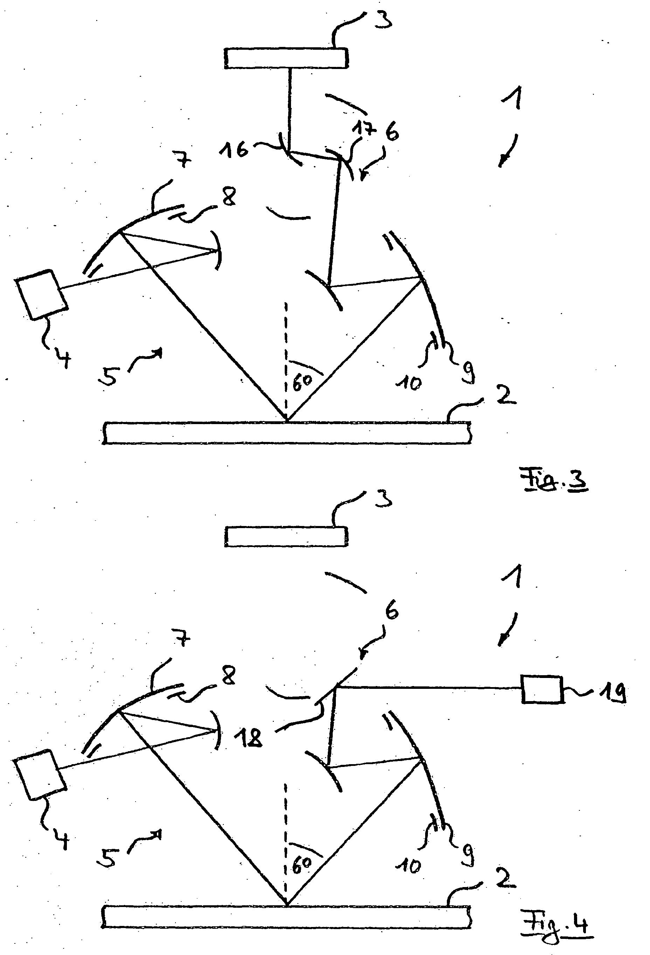

Figur 4 zeigt eine weitere Variante, die den Strahlengang des Abbildungsstrahlenganges 6 mittels eines einschwenkbaren Umlenkspiegels 18 auf ein eigenständiges Abbildungssystem in Form einer Pupillenkamera 19 ausköppelt. Die Pupillenkamera 19 ist dabei so ausgeführt, daß sie eine Abbildung der Pupillen von NA-Blende 10 und Sigma-Blende 8 ermöglicht, um das eingangs geschilderte Justierverfahren durchzuführen. Im Gegensatz zu den Ausführungsformen der Figuren 1 bis 3 erfolgt also die Abbildung der Pupillen nicht auf die im AIMS 1 vorgesehene Kamera 3.

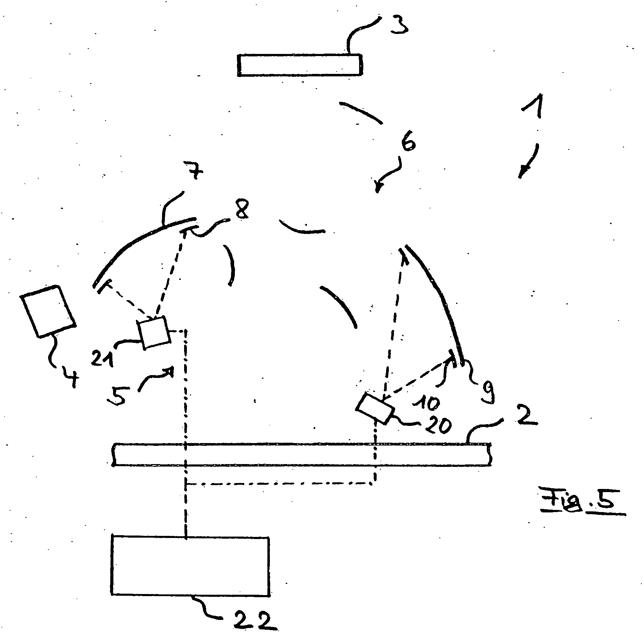

Figur 5 zeigt eine weitere Ausführungsform der Justierabbildungseinrichtung, die zwei getrennte eigenständige Pupillenkameras aufweist. Eine NA-Pupillenkamera 20 erfaßt die Lange der NA-Blende 10, eine Sigma-Pupillenkamera 21 die Lage der Sigma-Blende 8. Die Pupillenkameras 20 und 21 liefern ihre Daten an eine Steuereinheit 22, die unter Berücksichtigung der Lage der Pupillenkamera 21 und 20 zum Strahlengang des AIMS 1 eine entsprechende Zentrierung der Blenden 8 und 10 ermöglicht. Die Pupillenkameras 20 und 21 arbeiten dabei bei einer anderen Wellenlänge, können also kostengünstig ausgeführt werden. Zum Justieren muß also die Strahlungsquelle 4 des AIMS 1 nicht betrieben werden; dieser Zustand ist in Figur 1 auch dargestellt. Natürlich ist auch hier das obige Justierkonzept anwendbar.

Eigenständige Pupillenkameras 20 und 21 erlauben weiter parallelen Meß- und Überwachungsbetrieb in verschiedenen Wellenlängenbereichen und damit eine aktive Stabilisierung des Strahlenganges im Wege einer Regelung, bei der die Signale der Pupillenkameras 20 und 21 ausgewertet werden.

## Patentansprüche

1. Optisches Abbildungssystem, das ein Objekt (2) in eine Bildebene (3) abbildet und das aufweist
- einen Beleuchtungsstrahlengang (5), in den Beleuchtungsstrahlung in einem Wellenlängenbereich unterhalb 100 nm eingekoppelt wird und der zur Einstellung der numerischen Apertur der Beleuchtung eine Sigma-Blende (8) aufweist, und
- einen Abbildungsstrahlengang (6), der zur Einstellung der numerischen Apertur der Abbildung eine NA-Blende (10) aufweist und in der Bildebene (3) ein vergrößertes Bild der Maske (2) erzeugt,
- wobei Beleuchtungs- und Abbildungsstrahlengang (5, 6) eine reflektive Optik (7, 9) aufweisen, **dadurch gekennzeichnet, daß**
- eine Justierabbildungseinrichtung (11, 15, 16, 17, 6) vorgesehen ist, die die gegenseitige Lage von Sigma- und NA-Blende (8, 10) abbildet.

2. Abbildungssystem nach Anspruch 1, **dadurch gekennzeichnet, daß** die Justierabbildungseinrichtung zwei Pupillenkameras (20, 21) umfaßt, die die Lage der Sigmaund NA-Blende (8, 10) erfassen, wobei die Pupillenkameras (20, 21) auf einen bezüglich den Beleuchtungs- und Abbildungsstrahlengang (6) festliegenden Referenzpunkt in bekannter Lage fixiert oder fixierbar sind.

3. Abbildungssystem nach Anspruch 1, **dadurch gekennzeichnet, daß** die Justierabbildungseinrichtung eine in den Abbildungsstrahlengang (6) schaltbare Fresnellinse (11) umfaßt, die die Pupillen der Sigma- und NA-Blende (8, 10) in die Bildebene (3) abbildet.

4. Abbildungssystem nach Anspruch 3, **dadurch gekennzeichnet, daß** Material und Linsendicke der Fresnellinse (11) eine vorbestimmte Dämpfung im Abbildungsstrahlengang bewirkt.

5. Abbildungssystem nach Anspruch 1, **dadurch gekennzeichnet, daß** die Justierabbildungseinrichtung einen Abbildungsspiegel (15) umfaßt, der über mindestens zwei in den Abbildungsstrahlengang schaltbare Spiegel (13, 14) in den Abbildungsstrahlengang (6) einkoppelbar ist und der die Pupillen der Sigma- und NA-Blende (8, 10) in die Bildebene (3) abbildet.

6. Abbildungssystem nach Anspruch 1, **dadurch gekennzeichnet, daß** die Justierabbildungseinrichtung eine Pupillenkamera (19) umfaßt, die über einen in den Abbildungsstrahlengang (6) schaltbaren Spiegel (18) in den Abbildungsstrahlengang (6) einkoppelbar ist und die die Pupillen der Sigma- und NA-Blende (8, 10) erfaßt.

7. Abbildungssystem nach Anspruch 2 oder 6, **dadurch gekennzeichnet, daß** die Pupillenkamera (19) bei einem vom Wellenlängenbereich der Beleuchtungsstrahlung verschiedenen Arbeitswellenlängenbereich arbeitet.

8. Abbildungssystem nach Anspruch 7, **gekennzeichnet durch** eine aktivierbare, vorzugsweise in den Beleuchtungsstrahlengang einschiebbare, Hilfsquelle, die für die Justierabbildungseinrichtung (2) Beleuchtungsstrahlung im Arbeitswellenlängenbereich bereitstellt.

9. Abbildungssystem nach Anspruch 1, **dadurch gekennzeichnet, daß** die Justierabbildungseinrichtung (2) in den Abbildungsstrahlengang (6) schaltbare abbildende Spiegel (16, 17) aufweist, die die Pupillen der Sigma- und NA-Blende (8, 10) in die Bildebene (3) abbildet.
